# EUROPEAN PATENT SPECIFICATION

(11) **EP 0 380 876 B1**
(45) Date of publication and mention of the grant of the patent: **14.02.1996**
(21) Application number: 89312820.7
(22) Date of filing: 08.12.1989
(51) Int. Cl.: H04L 27/22, H03M 13/12, H03M 13/00

(54) **Phase synchronous maximum likelihood decoder**
Phasensynchroner Maximalwahrscheinlichkeitsdekodierer
Décodeur à probabilité maximale synchrone en phase

(30) Priority: 08.12.1988 JP 310919/88
(43) Date of publication of application: 08.08.1990
(73) Proprietor: KABUSHIKI KAISHA TOSHIBA, Kawasaki-shi, Kanagawa-ken 210, Tokyo (JP)
(72) Inventor: Serizawa, Mutsumu, Minato-ku Tokyo (JP); Murakami, Junzo, Minato-ku Tokyo (JP)
(74) Representative: Freed, Arthur Woolf

(56) References cited:
- MILCOM 87- IEEE MILITARY COMMUNICATIONS CONFERENCE 19 October 1987, WASHINGTOND.C. pages 87 - 93; R.A. DIFAZIO, J.G. GORELICK: 'Communication system designusing m'ary ful and partial response continuous phase modulation'
- IEEE TRANSACTIONS ON COMMUNICATIONS. vol. 33, no. 6, June 1985, NEW YORK USpages 535 - 542; J.B. THORPE, P.J. MCLANE: 'A hybrid phase/data Viterbidemodulator for encoded CPFSK modulation'
- IEEE TRANSACTIONS ON COMMUNICATIONS. vol. 35, no. 7, July 1987, NEW YORK USpages 764 - 767; P.Y. KAM: 'Maximum-likelihood digital data sequence estimationover the gaussian channel with unknown carrier phase'
- IEEE TRANSACTIONS ON INFORMATION THEORY. vol. 27, no. 5, September 1981, NEWYORK US pages 581 - 595; O. MACCHI, L.L. SCHARF: 'A dynamic programmingalgorithm for phase estimation and data decoding on random phase channels'
- IEEE TRANSACTIONS ON COMMUNICATION TECHNOLOGY. vol. 19, no. 3, June 1971, NEWYORK US pages 268 - 280; H. KOBAYASHI: 'Simultaneous adaptive estimation anddecision algorithm for carrier modulated data transmission systems'

## Description

The present invention relates to a detection and determination of data within a range having a low signal-to-noise ratio (referred to as a S/N ratio hereinafter) in a communication or a recording device etc., and more particularly, relates to a phase synchronous type maximum likelihood decoder for transmitting and receiving digital signals.

In recent years, it has been noticed the receiving system in which modulation signals in a broad sense involving the phase modulation of convolution ally encoded data or an orthogonal amplitude modulation, an encoded modulation, CPFSK and a modulation having an interference between the symbols are detected with Maximum Likelihood Sequence Estimation Scheme, because it provides the satisfactory S/N ratio against error rate characteristics.

The maximum likelihood sequence estimation system as mentioned above, is structured to estimate a transmit data sequence with the minimum error on the basis of reference signals which are hypothetical ideally detected signals.

Since the maximum likelihood determination system has the advantages that the remarkable low error rate can be expected in the low S/N ratio range which the other system cannot achieve, it has been considered widely in various fields. Namely, it is provided with the system which can result the approximate maximum likelihood determination in the radio communication using remarkably complicated transmission path environment. Therefore, the demodulation means are required to be structured to result the low error rate in such low S/N ratio. For carrying out the maximum likelihood decode, it is generally utilized the coherent detection which excels in the error rate characteristics.

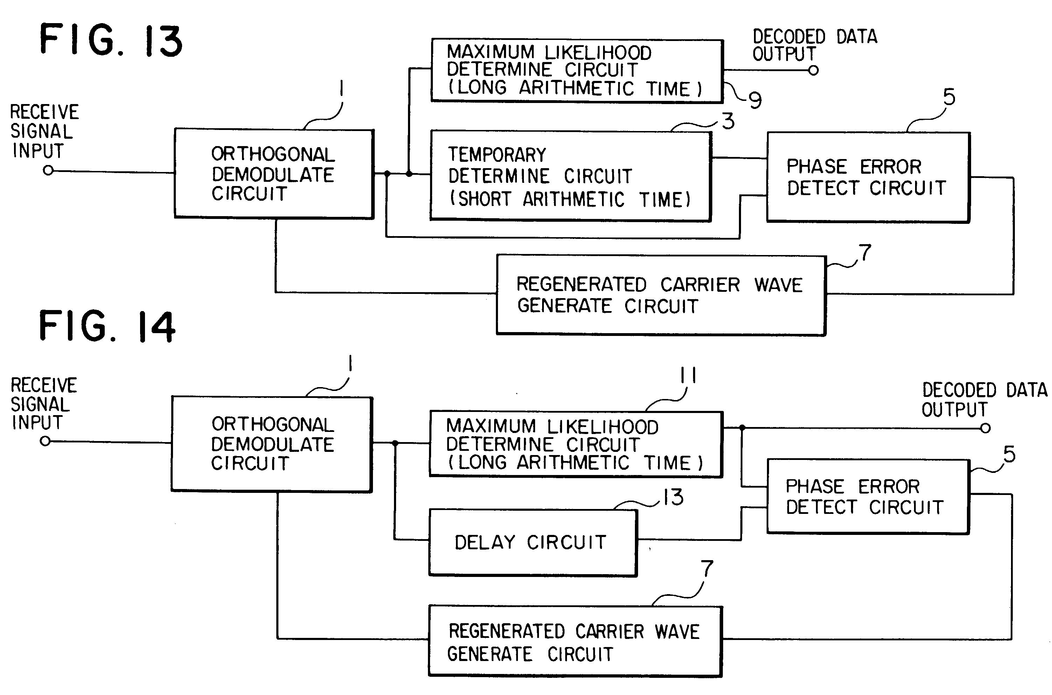

Fig. 13 is a block diagram showing the structure of the phase synchronous circuit in such synchronous detection system. As shown in the drawing, the phase synchronous circuit is provided with an orthogonal demodulation circuit 1, a temporary detection circuit 3, a phase error detect circuit 5, a regenerated carrier wave generate circuit 7 and a maximum likelihood sequence estimation 9.

The orthogonal demodulate circuit 1 demodulates orthogonally the received signals. The temporary detection circuit 3 detect the transmitted data with immediate detection scheme. The phase error detect circuit 5 detects the phase errors of output signals using the outputs of the orthogonal demodulation circuit 1 and the temporary determine circuit 3.

The regenerated carrier wave generate circuit 7 generates the regenerated carrier wave controlled by the output of the phase error detection circuit 5. The maximum likelihood sequence estimation circuit 9 determines the transmit signal with maximum likelihood on the basis of the output signal of the orthogonal demodulation circuit 1.

In the phase synchronous circuit as mentioned above, the phase error between the regenerated carrier wave and the carrier wave of receive signal is calculated on the basis of the transmit data detected by the temporary detection circuit 3 in a certain form, and controls the phase of the regenerated carrier wave.

However, in such phase synchronous loop, when 'the data determined in'a certain form" is not correct, the incorrect phase error is calculated and the phase of regenerated carrier wave is controlled on the basis of the incorrect phase error, therefore, the synchronous characteristics cannot be obtained satisfactorily. The phase error calculated on the basis of the correct phase error is structured to have a Gaussian random noise added to the adjust phase error, therefore, the noise component can be removed by means of a linear filter, if the movement of the phase of transmit carrier wave is within a certain range. As compared with this, since the phase error calculated on the basis of the incorrect transmitted data is structured to have not only the Gaussian random noise added to the adjust phase error, but also the incorrect data acting to be a nonlinear noise, it causes the difficulty to hold the synchronization when the error exceeds a certain range. Further, it can be assumed how it is difficult to synchronize in the condition when the phase of transmit carrier wave is moved suddenly.

Namely, for obtaining the satisfactory phase tracking characteristics, it is required to reduce the delay in the loop. Therefore, the phase error is to be calculated on the basis of the temporary determined data involving larger amount of errors than the maximum likelihood sequence estimation method, and the sufficient operation cannot be carried out on forming frequently the inferior, such as a synchronization failure, in the low S/N ratio. As a result, it cannot be obtained "the data having much less presumed errors" which is the final object in the low S/N ratio.

Fig. 14 is a block diagram showing the structure of another phase synchronous circuit, and this phase synchronous circuit is provided with an orthogonal demodulate circuit 1, a maximum likelihood sequence estimation circuit 11, a delay circuit 13, a phase error detect circuit 5 and a regenerated transmit carrier wave generate circuit 7.

The delay circuit 13 delays an output signal of the orthogonal demodulate circuit 1. The maximum likelihood sequence estimation circuit 11 determines the maximum likelihood sequence of the transmit signal on the basis of the output signal from the orthogonal circuit 1. The phase error detect circuit 5 detects the phase errors between the outputs of the orthogonal demodulate circuit 1 and the MLSE (Maximum Likelihood Sequence Estimation) circuit 11. The regenerated carrier wave generate circuit 7 generates the regenerate carrier wave on the basis of the output from the phase error detect circuit 5.

In the phase synchronous circuit as mentioned above, the phase error is calculated by the phase error detect circuit 5 on the basis of the transmit data with the maximum likelihood detected by the maximum likelihood determine circuit 11. The most reliable phase errors can be calculated by the system described above.

However, for determining the maximum likelihood of the transmit data, it is required a long period of time. It takes four or five times as much as inter-symbol-interference (ISI) or a constrained length of the convolutional code.

Further, the time for decoding is taken longer depending on the encodes. For example, on decoding such punctured convolution encode of the encode rate of 7/8, it is required the time nearly ten times as much as the constrained length, in general. In the circuit for controlling the regenerated carrier wave by utilizing the phase error calculated on the basis of the transmit data determined in a long period of time includes the remarkably large delay time in the control loop, therefore, it is resulted the remarkable poor characteristics in the phase tracking. Namely, it is caused disadvantages that the frequency tracking range becomes remarkably narrow, the loop becomes easily unstable and the time period required for the synchronization is taken remarkably long.

In the phase synchronization circuit, the delay in the loop becomes longer, the sufficient phase tracking characteristics cannot be obtained. Therefore, it is caused the synchronization failure in the loop if phase of the carrier wave varies slightly. As a result, it cannot be obtained "the data having much less presumed errors".

As described above, it is hard to obtain the maximum likelihood sequence estimation and the phase synchronization of the CPFSK signals having the large interference between the codes, and especially, the coherent detection in the low S/N ratio is remarkably hard to obtain. Further, when the maximum likelihood S.E. system is used in the satellite mobile communication and the land mobile communication, it is hard to obtain the carrier phase synchronization, because the carrier phase is remarkably fluctuated by the complicated transmission path characteristics, such as a multipath fading and a shadowing. It is limited only the case having the relatively moderated transmission path characteristics, such as a Rice or the case the transmitted signals contain the pilot signal or preamble in order to assist the easy synchronization. Further, the ratio of whole signals occupied by the preamble or the pilot is remarkably high, therefore, it is so far from the effective utilization of the transmit path. And it has been hard to provide an effective preamble or pilot.

As described above, there has not been provided such phase synchronous means which operates satisfactorily in the low S/N ratio, provides satisfactory phase tracking characteristics and is suitable for the maximum likelihood sequence estimation. Therefore, it has been caused the problem that the maximum likelihood sequence estimation cannot be achieved in the range of the low S/N ratio in spite of various advantages.

A continuous phase modulation receiver utilising the maximum likelihood sequence estimation (or Viterbi) algorithm is studied in the paper "Communication System Design Using M'ary Full and Partial Response Continuous Phase Modulation"; R.A. Difazio, J.G. Gorelick, published in Hilcom 87-IEEE Military Communications Conference, 19 October 1987, pages 87-93.

The present invention has been done in view of the disadvantages as mentioned above, and aims at providing the phase synchronous type maximum likelihood decode system which is capable of operating satisfactorily in the low S/N ratio and providing the satisfactory phase tracking characteristics.

For achieving the object as mentioned above, the phase synchronous type maximum likelihood decoder of the present invention is provided with a memorize means for memorizing N number of partial series possibly transmitted from the transmit side, N number of phase adjust means for adjusting the phase of the partial series in the received data series transmitted from the transmit side on the basis of the partial series memorized in the memorize means, a means for calculating a likelihood for the partial series on the basis of the partial series memorized in the memorize means and the partial series with adjusted phase output from the phase adjust means, and a means for selecting the partial series having the maximum likelihood from the memorize means on comparing calculated N number of the likelihood.

In the present invention, N number of partial series in the transmit data series possibly transmitted from the transmit side is memorized and the phase of the partial series in the transmit data series transmitted from the transmit side is adjusted on the basis of the memorized partial series, the likelihood for the partial series transmitted from the transmit side is calculated on the basis of the memorized partial series and the partial series with adjusted phase, the calculated N number of likelihood are compared and the partial series having the maximum likelihood is selected from the memorize means.

By the present invention, it can be provided the phase synchronous type MLSE system which operates satisfactorily in the low S/N ratio and provides the satisfactory the phase tracking characteristics.
Fig. 1 is a block diagram showing the structure of a phase synchronous type maximum likelihood decoder according to an embodiment'of the present invention;
Fig. 2 is a transition diagram showing a state in the Viterbi algorithm;
Fig. 3 is a block diagram showing the structure of a receive system involving the maximum likelihood decoder;
Fig. 4 is a block diagram showing schematically the structure of a Viterbi algorithm arithmetic part 68 in Fig. 3;
Fig. 5 is a block diagram showing the structure of the Viterbi algorithm arithmetic part 68 in Fig. 3;
Fig. 6 is a graph showing an error characteristics as a simulation result of the present embodiment;
Figs. 7 through 9 are graphs showing the phase synchronous characteristics of the present embodiment;
Fig. 10 is a block diagram showing another structure of the Viterbi algorithm arithmetic part 68 in Fig. 3;
Fig. 11 is a block diagram showing the structure of the receive unit using the Viterbi algorithm;
Fig. 12 is a view showing the algorithm of the Viterbi algorithm on the basis of the state transition diagram; and
Figs. 13 and 14 are block diagrams showing the structure of the conventional phase synchronous circuit.

Now, an embodiment of the present invention will be explained below in detail with reference to the drawings.

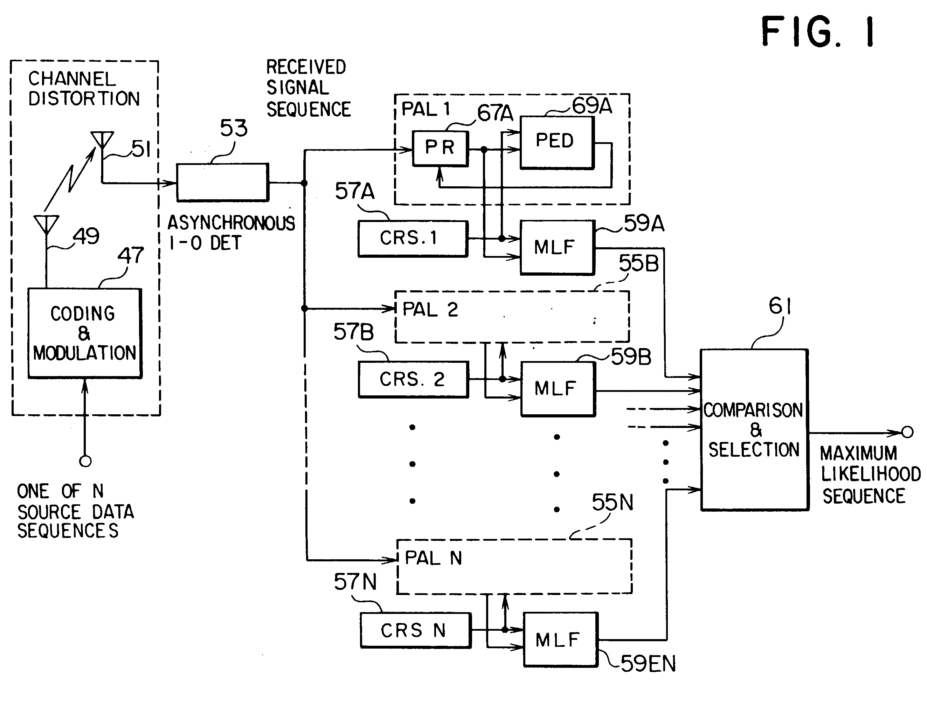

Fig. 1 is a block diagram showing the structure of a phase synchronous maximum likelihood decoder according to the first invention.

As shown in the figure, the phase synchronous type maximum likelihood decoder is provided with an antenna 51, a quasi synchronous detect part (an orthogonal detect part by asynchronous carrier) 53, a phase adjusting loops 55A, 55B,--- , and 55N, signal series memory parts 57A, 57B, ---, and 57N, likelihood function calculate parts 59A, 59B, ---, and 59N, and a compare and select part 61.

A coding and modulation part 47 and an antenna 49 are provided in the transmit side.

Either one of N number of the partial series in the transmit series is input into the coding and modulation part 47 and is transmitted to the receive side through the antenna 49 on being coded and modulated.

The quasi synchronous detect part 53 orthogonally demodulates the signal series received in the receive side antenna 51 by using the asynchronous carrier.

The phase adjusting loop 55A is provided with a phase shifter 67A and a phase error detecter 69A.

The signal series memory parts 57A --- 57N memorize N number of the partial series in the transmit data series possibly transmitted from the transmit side.

The phase adjusting loops 55A --- 55N adjusts one of phase of the partial series in N number of partial series in the transmit side transmitted from the transmit side on the basis of the partial series memorized in each signal series memory part 57A --- 57N.

The likelihood function calculate part 59A --- 59N calculate the likelihood of the partial series in the transmit data series transmitted from the transmit side on the basis of the partial series memorized in each signal series memory part 57A --- 57N and the partial series output from the phase adjusting loops 55A --- 55N.

The compare and select part 61 compares the calculated N number of the likelihood and selects the partial series having the maximum likelihood.

Next, the operation of the present embodiment will be explained. First, it will be explained regarding the maximum likelihood determination. In the maximum likelihood determination, for receiving a signal it is searched the highest probability (likelihood) which partial series is transmitted among the possibly transmitted partial series when a signal is received. And it is determined that the partial series having the highest probability is transmitted.

Namely, for the maximum likelihood determination, it is calculated every likelihood corresponding to each signal series over all possibly transmitted signal series, then, the transmit signal having the maximum likelihood is selected among these calculated likelihoods. When the receive signal is input, if the phase synchronization of the carrier wave of the receive signal and the regenerated carrier wave are completed, the likelihood regarding the case in which all the possibly transmitted signal series are assumed to be transmitted can be determined.

However, the phase synchronization of the receive signal is not actually achieved.

Therefore, in the present embodiment, the series of the phase error, regarding the case in which all the possibly transmitted signal series memorized in the signal series memorize parts 57A, 57B --- memorizing the possibly transmitted signal series are assumed to be transmitted, is determined by the phase error detect parts 69A, 69B --- when the phase asynchronous receive signals are added to the carrier wave.

If there is a certain limitation in the severe movement of the phase of carrier wave, the movement of the phase of carrier wave minimizing the phase error can be determined when the series of the phase error is determined. When the movement of the phase of carrier wave is determined, the likelihood, regarding the case in which all the possibly transmitted signals are assumed to be transmitted, is determined by the likelihood function calculate parts 59A, 59B ---. When the likelihood regarding the possibly transmitted transmit data is calculated, the maximum likelihood is selected by the compare and select part 61. And it is presumed which series has the highest possibility to be transmitted among the possibly transmitted signal series for the received signals. Further, the movement of the phase of carrier wave in the receive signals is presumed.

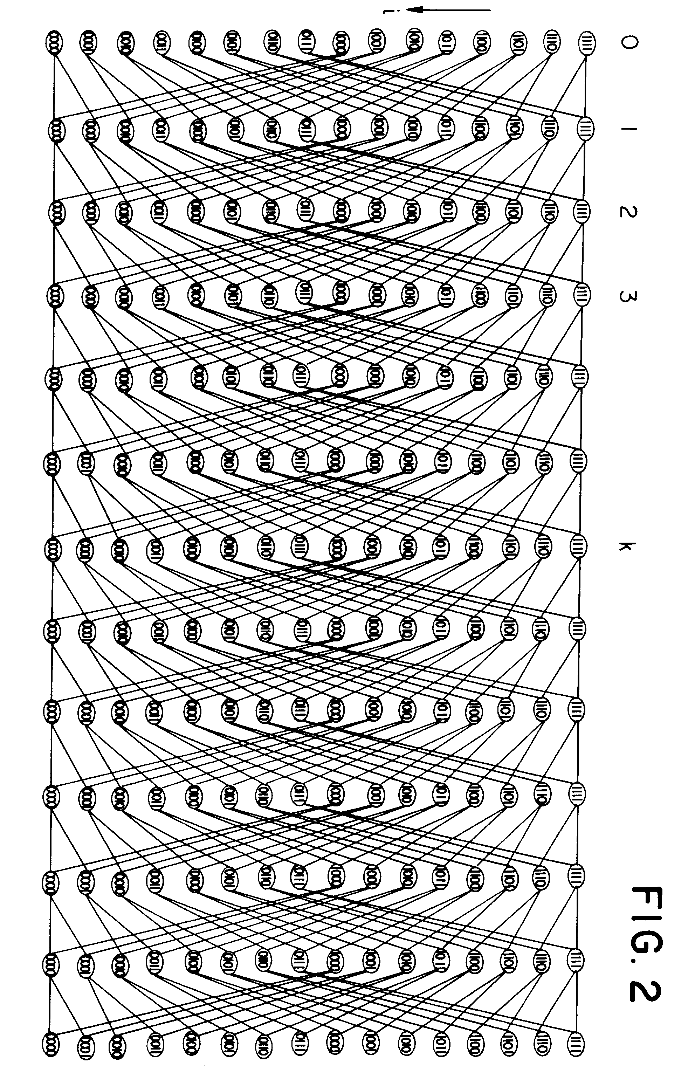

Next, an embodiment of the phase synchronous maximum decoder in which the Viterbi algorithm is used will be explained. Fig. 2 is a transition diagram showing the state in the Viterbi algorithm. The time is shown in a horizontal direction, and the state is shown in the vertical direction. Namely, it can be considered the state [1111], [1110], ---, [0000] when the state i (i = 1, ---, 16) is expressed in the time k.

The numeric value indicated in each state (for example [1111]) shows the partial series of the transmit data series possibly transmitted from the transmit side.

Regarding the Viterbi algorithm, it is described in detail in "New Digital Satellite Communication" by JATECH Publications, such as "The Viterbi Algorithm" by G. David FORNEY, Jr., "Proceedings of the IEEE, vol 61 No. 3 in March 1973, and "VIJAY" by K. BHARGAVE.

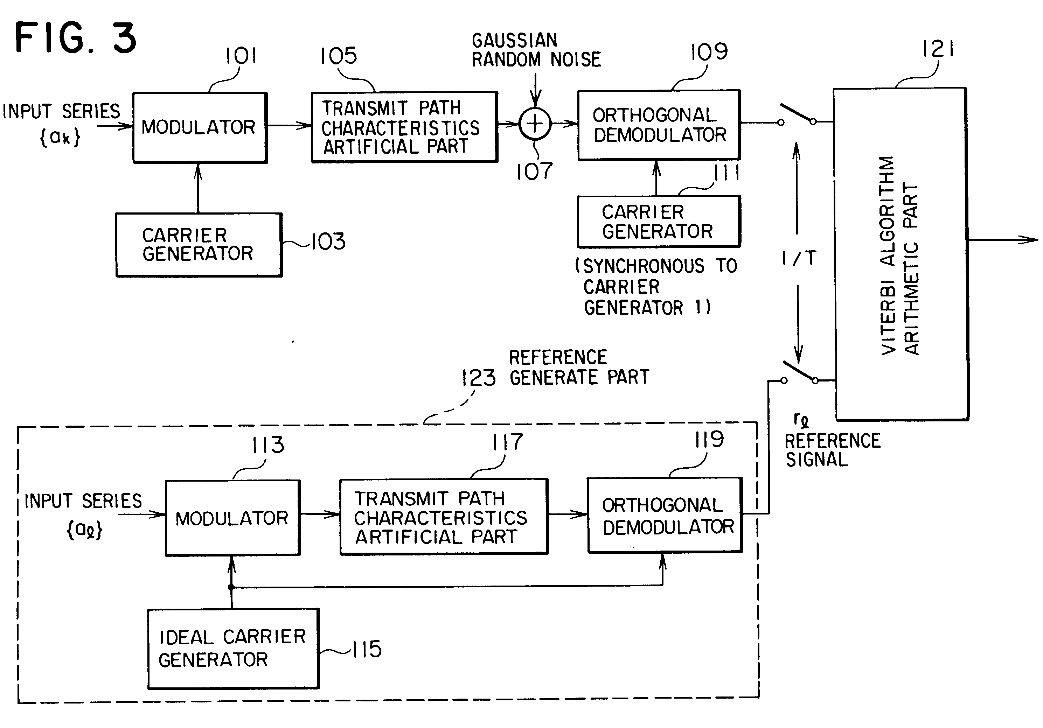

Fig. 3 is a block diagram showing the structure of the receive system applied to an embodiment using the Viterbi algorithm.

As shown in the figure, this receive system is provided with a modulator 101, a carrier generator 103, a transmission path characteristics artificial part 105, an adder 107, an orthogonal demodulator 109, a carrier generator 111, a modulator 113, an ideal carrier generator 115, a transmission path characteristics artificial part 117, an orthogonal demodulator 119 and a Viterbi algorithm arithmetic part 121.

A reference signal generate part 123 is provided with the modulator 113, the ideal carrier generator 115, the transmission path characteristics artificial part 117 and the orthogonal demodulator 119.

The modulator 101 modulates an input series (a ₖ) which is the transmit data series by using the carrier transmitted from the carrier generator 103.

The carrier generator 103 supplies the carrier to the modulator 101. The transmission path characteristics artificial part 105 supplies the transmission characteristics to the signals, for example the random noise is supplied to the signals transmitted from the modulator 101. The adder 107 adds the Gaussian random noise to the signals passed through the transmission path characteristics artificial part 105 and transmits to the orthogonal demodulator 109. The orthogonal demodulator 109 performs the demodulation by using the carrier generated in the carrier generator 103 and the asynchronous carrier generated by the carrier generator 111 generating the asynchronous carrier for the signals supplied with the Gaussian random noise to output the demodulated output signal.

The modulator 113 modulates an input series (a _{ℓ}) which is the transmit data series by using the carrier transmitted from the ideal carrier generator 115.

The ideal carrier generator 115 supplies an ideal carrier to the modulator 113. The transmission path characteristics artificial part 117 supplies the signals the transmission characteristics to the signals, for example, the random noise is supplied to the signals transmitted from the modulator 113. The orthogonal demodulator 119 performs the demodulation by using the carrier generated in the ideal carrier generator 115 for the output signals from the orthogonal demodulator 117 to output the reference signal rℓ.

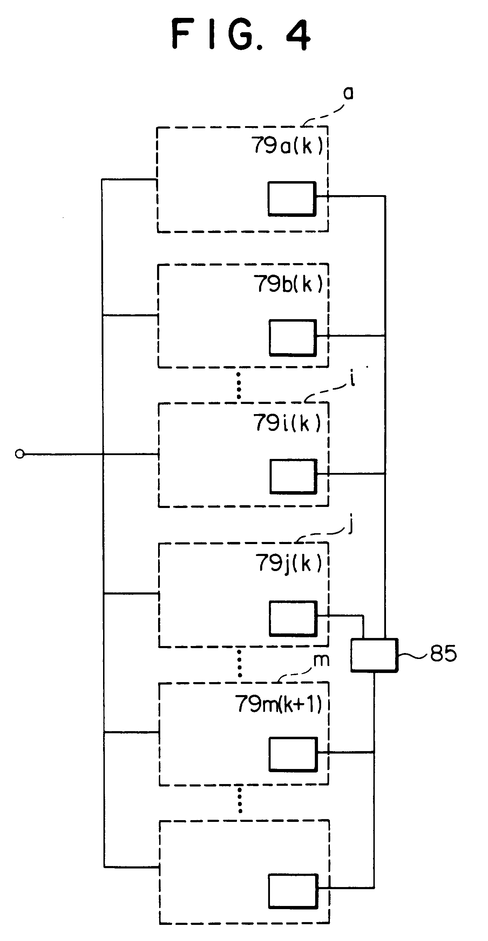

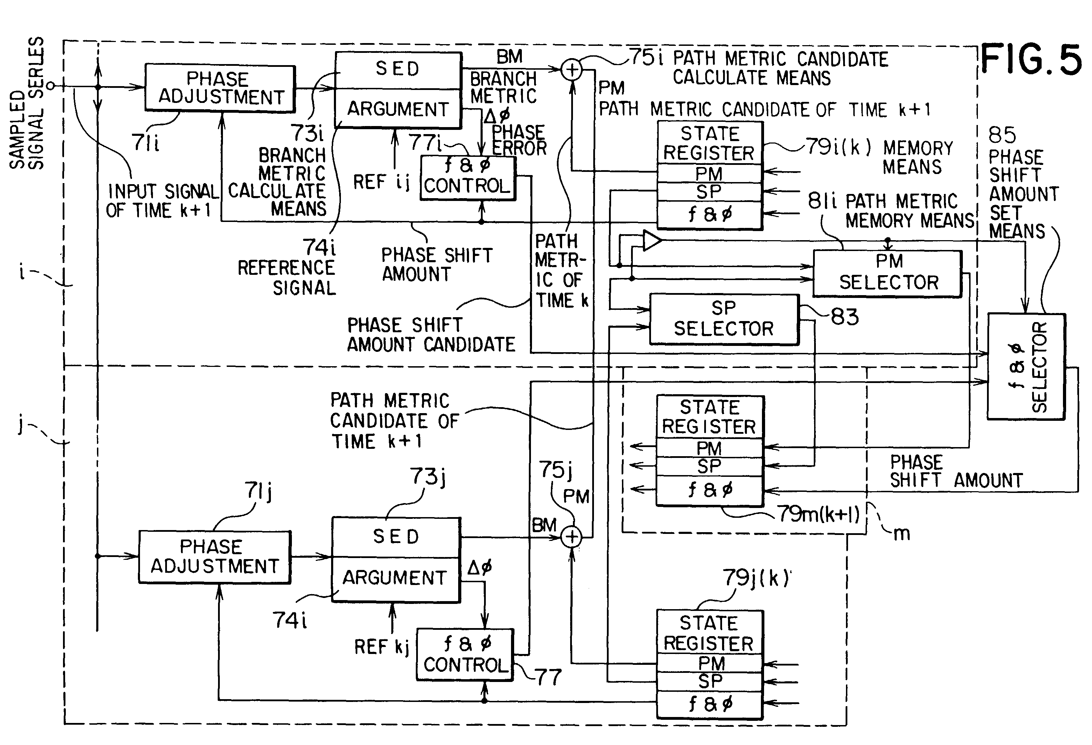

Fig. 4 is a block diagram schematically showing the structure of the Viterbi algorithm arithmetic part 68. Fig. 5 is a block diagram showing in detail the structure of the Viterbi algorithm arithmetic part 68.

Namely, Fig. 5 shows the structure of the device in the state i and the state j, and the state memory 79 in the state m in Fig. 4.

The structures of the device in the state i (i = 1 through 16) are all similar to each other.

The Viterbi algorithm arithmetic part 68 is provided with a phase adjusting part 71i (i = 1, ---, 16), a branch metric calculate part 73i, an adder 75i as a path metric candidate calculate part, a phase shift amount candidate calculate part 77i, a state memory 79i as a memory means, a path metric selector 81i, a selected path selector 83i and f & φ selector 85i as a phase shift amount set means.

The phase adjusting part 71i shifts the phase of the input signal of time (k + 1) in the phase shift amount of the time k memorized in the state memory 79i.

The branch metric calculating part 73i calculates the branch metric BM on evaluating the difference between the reference signal r_{ef} which is a vector on the complex number plane corresponding to each transition to the state of a plurality of time (k + 1) possibly transited from each state of the time k in the state i and the input signal having the adjusted phase output from the phase adjusting part 71i.

The phase error calculating part 74i calculates the phase error which is the angle difference between the input signal output from the phase adjusting part 71i in the state i and the reference signal r_{ef}.

The adder 75i as the path metric candidate calculate means calculates the time k memorized in the state memory means 79i, the time (k + 1) having the path metric PM in the state i added to the branch metric BM output from the adder 75i in the state i, and the path metric candidate PM in the state i.

The phase shift amount candidate calculating 77i calculates the time k memorized in the state memory 79i and the phase shift amount candidate f & φ from the state i to the state m on the basis of the phase shift amount f & φ in the state i and the phase error output from the phase error calculating part 74i.

The state memory 79i as the memory means memorizes the time k, the path metric PM in the state i and the selected path SP and the phase shift amount f & φ.

The path metric selector 81 as the path metric set means compares a pair of path metric candidates PM calculated in the adder 75i and 75j in accordance with the transition from the state i and the state j of the time k to the state m of the time (k + 1), and sets the time (k + 1) and the path metric of the state m.

The selected path selector 83 selects the path.

The phase shift amount setting part 85i sets the phase shift amount candidate f & φ corresponding to the selected transition as the phase shift amount when either the transition of the time k from the state i to the state j or the transition of the time (k + 1) to the state m is selected by the path metric selector 81 and written in the state memory 79m in the time (k + 1) and the state m.

For example, when the transition of time k, the time (k + 1) in the state m and the transition to the state m is selected, the phase shift amount candidate f & φ corresponding to the transition (namely, the phase shift amount candidate calculated in the phase shift amount calculation m77i) is selected and written in the state memory 79m in the time (k + 1) and state m.

Next, the operation of the Viterbi algorithm arithmetic part 68 will be explained.

In the Viterbi algorithm, the constant number of the remaining path and the path metric corresponding to each path are sequentially updated to determine the transmit series having the maximum likelihood.

The phase control is carried out to each regenerated carrier wave in accordance with the proper phase error of each remaining path on assuming each remaining path has the regenerated carrier wave (phase adjusting loop, phase shift amount). Namely, each remaining path has the proper transmit data series, so, it has the proper phase error series. Therefore, the Viterbi algorithm arithmetic part 68 synchronizes the carrier wave independently to each remaining path on the basis of the proper phase error series of the remaining path. Namely, the calculation for the branch metric is carried out on the basis of the phase of regenerated carrier wave presumed by "the phase synchronizing loop" corresponding to the remaining path being to the state as the origin of the branch.

The reference signal r_{ef} used for the calculation of the branch metric BM carries out the phase shifting for the vector on the complex plane determined from the transmit data series signal possibly transmitted from the transmit side, which is determined in accordance with the transition according to the branch metric BM calculated by using the reference signal r_{ef} and the state i being as the origin of the transition so far as the phase shift amount f & φ memo-rized in accordance with the state being as the origin of the transition. Further, the reference signal r_{ef} assumes the phase shift amount candidate value f & φ which is adjusted by using the phase shift amount memorized in accordance with the state being as the origin of the transition with at least one of reference signal r_{ef} used for calculating the branch metric and the phase error φ as the angle difference to the input signal to be corresponded to the path metric candidate PM calculated by using the branch metric BM. When the path metric candidate is selected, the phase shift amount candidate f & φ corresponding thereto is selected as its path metric, then, it is assumed as new phase shift amount of the path metric of new state.

For example, when it is considered two transitions from the states i and j in the time k to the state m in the time (k + 1), a pair of branch metrics being one of state is calculated and added to the path metric of the origin of each branch to compare, and then, one of them is selected as the remaining path.

Namely, the path metric candidate PM from the state i in the time k to the state m in the time (k + 1) is calculated by means of the adder 75i.

And the path metric candidate PM from the state j in the time k to the state m in the time (k + 1) is calculated by means of the adder 75j.

The path metric setting part 81i compares a pair of path metric candidates PM and selects one of them.

Simultaneously, the regenerated carrier wave (phase shift amount) corresponding to the selected path is selected.

For example, when the path metric from the state i in the time k to the state m in the time (k + 1) is selected by the path metric setting part 81i, the phase shift amount setting part 85i selects the phase shift amount candidate f & φ from the state i in the time k to the state m in the time (k + 1).

Further, the phase of the regenerated carrier wave (phase shift amount) being as the origin of the selected branch is controlled by using the phase error signal calculated from the receive signal on the basis of the transmit signal corresponding to the selected signal, and the regenerated carrier wave (phase shift amount) corresponding to the remaining path is updated for the following receive signal.

As mentioned above, the synchronization of the phase is carried out on obtaining the maximum likelihood determine data.

Namely, the phase shift amount which is the supposed regenerated carrier wave relating to the path finally selected at the maximum likelihood is controlled by the phase error calculated on the basis of the maximum likelihood determine data.

Further, since the phase shift amount is controlled by the phase error calculated on the basis of the proper transmit data of the path in every update of the path metric, the delay in the loop is not caused.

Next, the algorithm in the receive system shown in Fig. 3 will be explained.

In the receive system, the input series (a ₖ) as the transmit data series is presumed at the maximum likelihood from the demodulated output signal (z ₖ) by the asynchronous carrier.

For presuming the input series (a ₖ), it is supposed following three matters.
1) the clock frequency (1/T) in the transmit and the receive are corresponded each other (phase shift is taken in the transmission path characteristics).
2) it is well known about the operative characteristics of the modulator and the impulse response of the transmission path (including the transmit and receive filter), the reference signal series (r ₖ) is obtained by the calculation on supplying the input series (a ₖ).
3) in the input series (a ₖ), there are a _{k-ν}, a _{k-ν+1}, ---, a ₖ plus (ν + 1) affecting to the demodulated output signal z ₖ as the receive signal of the time k as the operative characteristics of the modulator and the coherent between the codes by the impulse response of the transmission path.

The length of the partial series in the input series can be presented M = L^{ν} ways (L designates the level number of the input signal). The partial series having these M ways is called the "state". The parameter x ₖ designates what state in the time k is in the M ways. The relation to the input series can be defined as follows:${\text{x}}_{\text{k}} {\text{= (a}}_{\text{k-ν}} {\text{, a}}_{\text{k-ν+1}} {\text{' ---, a}}_{\text{k-1}} \text{)}$ Further, the time change, for example, the state x ₖ in the time k moves to the state x ₖ₊₁ in the time k+1, is called the "transition", and it can be expressed as follows:${\text{ξ}}_{\text{k}} {\text{(x}}_{\text{k+1}} {\text{' x}}_{\text{k}} \text{),}$ and ξ ₖ can be expressed as follows:${\text{ξ}}_{\text{k}} {\text{(a}}_{\text{k-ν}} {\text{, a}}_{\text{k-ν+1}} {\text{, ---, a}}_{\text{k-1}} {\text{' a}}_{\text{k}} \text{)}$

The time series (ξ ₖ) of the transition and the time series (x ₖ) of the state are corresponding to each other. And the time series (x ₖ) of the state and the input series (a ₖ) are corresponding to each other. Therefore, the time series (ξ ₖ) of the transition or the time series (x ₖ) of the state can be presumed in stead of presuming the input series (a ₖ).

Here, the state trellis in which M = L^{ν} is the state number is considered from the assumption (3), and the time series (x ₖ) of the state (so called, the "path") is presumed.

Next, the actual operation of the algorithm for presuming the maximum likelihood of the input series (a ₖ) from the demodulated output signal (z ₖ) will be explained. The following proceedings are carried out in the algorithm.

The phase adjusting loop (PAL) having same number as the state number M is provided independently. And the PAL is accorded to each remaining path (there is one in each state and is totally M). The phase of the origin signal (r ₖ) when the input series corresponding to the remaining path is supposed to be transmitted is adjusted by the output phase of the PAL to follow the phase of the receive signal. Then, the phase of the origin signal (r ₖ) used for calculating the branch metric is adjusted in every branch by using this.

In this algorithm, the demodulated output signal (z ₖ) is supplied as the input signal, and the origin signal (r ₖ) is supplied as the reference signal.

Here, the characters in this algorithm are redefined as follows:
- k ;: time
- x(xₖ), 1 ≦ xₖ ≦ M ;: remaining path wherein (xₖ) is its terminal
- γ (xₖ), 1 ≦ xₖ ≦ M ;: remaining path metric at (xₖ) terminal
- ω (xₖ), 1 ≦ xₖ ≦ M ;: instantaneous frequency of PAL pertaining to remaining path metric at (x ₖ) terminal
- ζ(xₖ), 1 ≦ xₖ ≦ M ;: output phase of PAL pertaining to remaining path metric at (x ₖ) terminal
- ε(xₖ), 1 ≦ xₖ ≦ M ;: phase error of PAL pertaining to remaining path metric at (x ₖ) terminal
- M ;: state number
and the initial values of each value is as follows;
k = 0
x(x ₀) = x ₀ ; x(m) is optional except m = x ₀
γ(x ₀) = 0 ; γ(m) = ∞ except m = x ₀
ω(m) = 0, 1 ≦ m ≦ M
ζ(m) = 0, 1 ≦ m ≦ M
ε(m) = 0, 1 ≦ m ≦ M

Next, the branch metric λ defined the following formula will be calculated to all transitions ζk(xₖ₊₁' xₖ).

The difference between the input signal zₖ which is the vector on the complex plane and each reference signal rₖ is numerated to obtain the branch metric.

The expressions λ [ ζₖ (xₖ₊₁, xₖ)] will be expressed abbreviately as λ (xₖ₊₁, xₖ), and this will be done similar to other parameters.${\text{λ (x}}_{\text{k+1}} {\text{, x}}_{\text{k}} {\text{) = ∥z}}_{\text{k+1}} {\text{- r1(x}}_{\text{k+1}} {\text{, x}}_{\text{k}} \text{)∥}$ wherein,${\text{r1(x}}_{\text{k+1}} {\text{, x}}_{\text{k}} {\text{) = r (x}}_{\text{k+1}} {\text{, x}}_{\text{k}} {\text{)/φ(x}}_{\text{k}} \text{)}$${\text{φ(x}}_{\text{k}} {\text{) = ζ(x}}_{\text{k}} {\text{) + 2πTf(x}}_{\text{k}} \text{)}$

Here, φ designates the shift amount, and the origin signal r(xₖ₊₁, xₖ) is shifted the phase so far φ.

This origin signal r(xₖ₊₁, xₖ) is used as the reference signal for calculating the branch metric.

As described above, for calculating the branch metric in the present embodiment, the value obtained by shifting the phase of the origin signal (reference signal) is used, and the shift amount φ is controlled by the phase error ω as described later.

Next, it is calculated the path metric candidate γ (xₖ₊₁, xₖ) in the time (k+1) through all the transitions on adding the calculated path metric λ (xₖ) in the time k with the branch metric λ obtained in the above described step.${\text{γ (x}}_{\text{k+1}} {\text{, x}}_{\text{k}} {\text{) = γ(x}}_{\text{k}} {\text{) + λ (x}}_{\text{k+1}} {\text{, x}}_{\text{k}} \text{)}$

Next, the state xₖ₊₁, and the path metric γ (xₖ₊₁) will be calculated through each state xₖ on the basis of the following formula with the calculated path metric candidate γ (xₖ₊₁, xₖ).${\text{γ(x}}_{\text{k+1}} {\text{) = min [γ(x}}_{\text{k+1}} {\text{, x}}_{\text{k}} \text{)]}$ obtained xₖ will be expressed as xₖ. This is the last term of the remaining path in which the state xₖ₊₁ is its terminal.

γ(xₖ₊₁) and the remaining path x(xₖ₊₁) corresponded to γ(xₖ₊₁) will be inserted into a certain position in the memory.

Therefore, the time series (xₖ) of the state can be obtained.

Next, it will be calculated the phase error ε(xₖ₊₁) of PAL pertaining the remaining path in which xₖ₊₁ is its terminal, the output phase ζ(xₖ₊₁), and the instantaneous frequency f(xₖ₊₁), and each obtained value will be inserted into a certain position in the memory.${\text{ε(x}}_{\text{k+1}} {\text{) = arg (z}}_{\text{k+1}} {\text{) - arg (r}}_{\text{k+1}} \text{)}$${\text{ω(x}}_{\text{k+1}} \text{) = (1 - γ)f(} {\text{x}}_{̲} {\text{}}_{\text{k}} {\text{) + (α + β)ε(x}}_{\text{k+1}} \text{) - αε(} {\text{x}}_{̲} {\text{}}_{\text{k}} \text{)}$${\text{ζ(x}}_{\text{k+1}} \text{) = ζ(} {\text{x}}_{̲} {\text{}}_{\text{k}} \text{) + 2πTf(} {\text{x}}_{̲} {\text{}}_{\text{k}} \text{) (= φ(} {\text{x}}_{̲} {\text{}}_{\text{k}} \text{))}$ wherein α, β, and γ are the positive integer, and are corresponding to the parameters describing the loop filter of the normal phase synchronizing loop as follows:
α ; gain of the direct proportion term X loop gain
β ; gain of the integral proportion term X loop gain
γ ; leak of the integrator

It can be known from the formulas (6), (7), and (8) that the phase shift amount φ is controlled by the phase error ε.

In such operation as mentioned above, the phase shift amount candidate value is obtained by adjusting the phase shift amount memorized in accordance with the state as the threshold of each branch metric on utilizing at least the reference signal used in the calculation of the branch metric and the phase error which is the angle difference to the input signal. And it is accorded to the path metric candidate calculated by utilizing the branch metric. And then, the phase shift amount candidate accorded to the selected path metric candidate is determined as the new phase shift amount of the state in which the path metric is selected.

Next, the result from the simulation of the present embodiment will be explained.

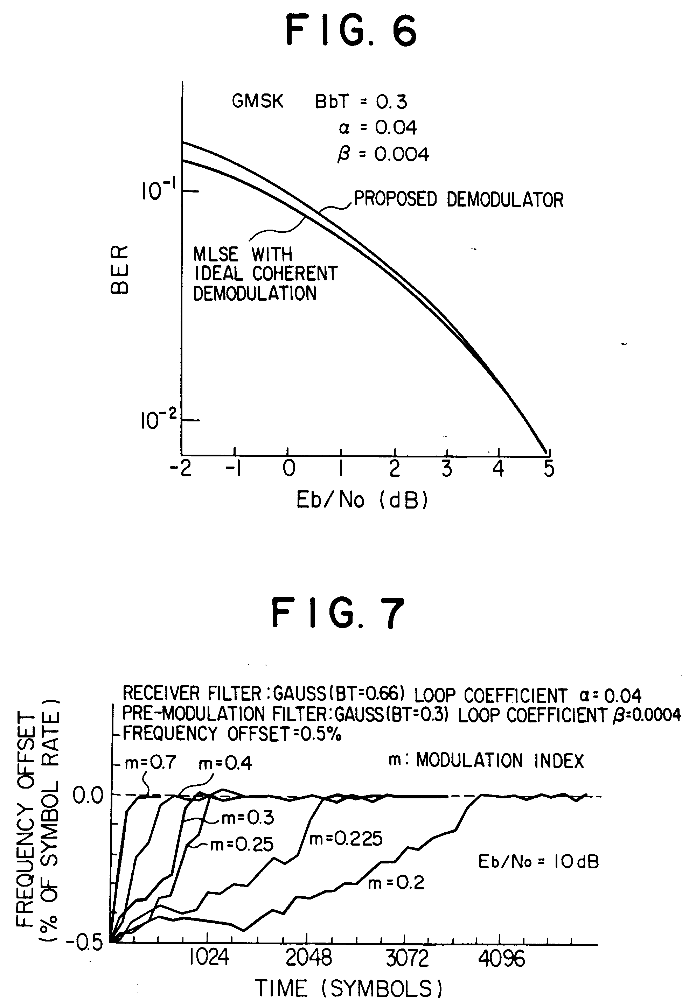

First, the error rate characteristics will be described. The error rate characteristics in the case wherein the differential coding GMSK (BbT = 0.3) is demodulated in accordance with the present invention is shown in Fig. 6 together with the case wherein the maximum likelihood series estimation is carried out on the basis of the ideal synchronous carrier (cribbing carrier). In the remarkably low S/N ratio range, a few deterioration is caused as compared with the maximum likelihood series estimation depending on the ideal synchronous carrier wave in the present invention, but the deterioration cannot be found in the normally used range exceeding Eb/No = 3dB. Therefore, it can be said that the present embodiment provides the demodulation system which is capable of operating satisfactorily in the low S/N ratio.

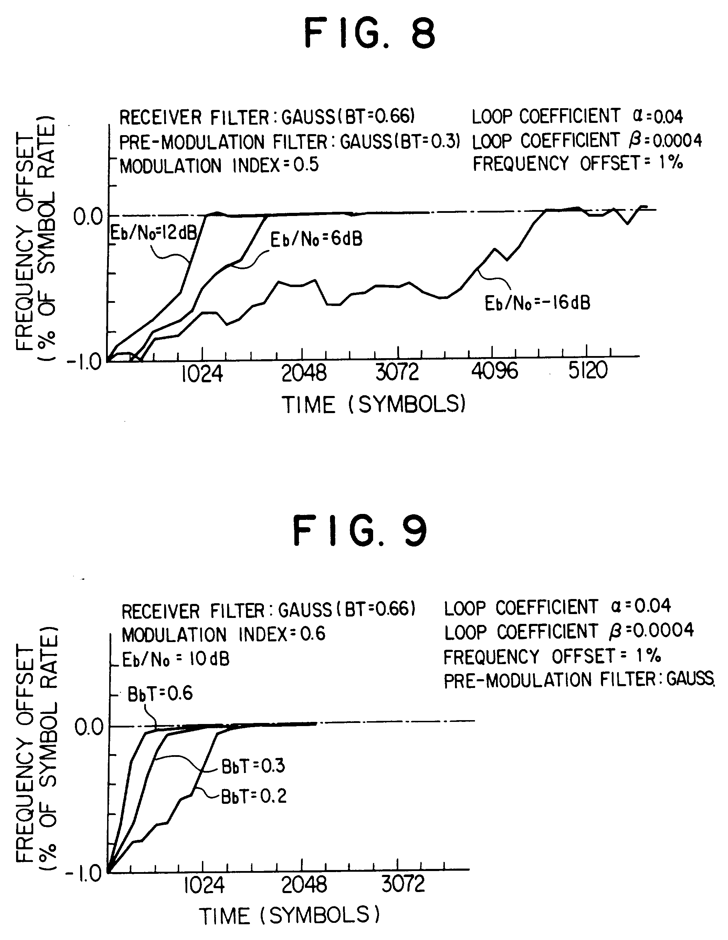

Next, it will be explained regarding the synchronous characteristics. The phase synchronous characteristics of the CPM system of the present embodiment is shown in Figs. 7, 8 and 9. Figs. 7, 8 and 9 show the synchronous steps on utilizing each modulation index, Eb/No, and the bandwidth of the filter before FM modulation indicating the length of the coherent between the codes as the parameter. In these figures, it can be confirmed that the phase synchronization and series estimation can be carried out satisfactorily in the wide range S/N range until about -2dB in Eb/No and in large coherent between the codes. Further, it can be known from these figures that the phase synchronous characteristics at high speed can be obtained when the modulation index is larger, the S/N ratio is larger and the coherent between the codes is smaller.

In the embodiment shown in Figs. 4 and 5 as described above, the input signal is shifted the phase for the calculation of the branch metric, it is possible to calculate the branch metric on shifting the phase of the reference signal in which the input signal is not shifted the phase.

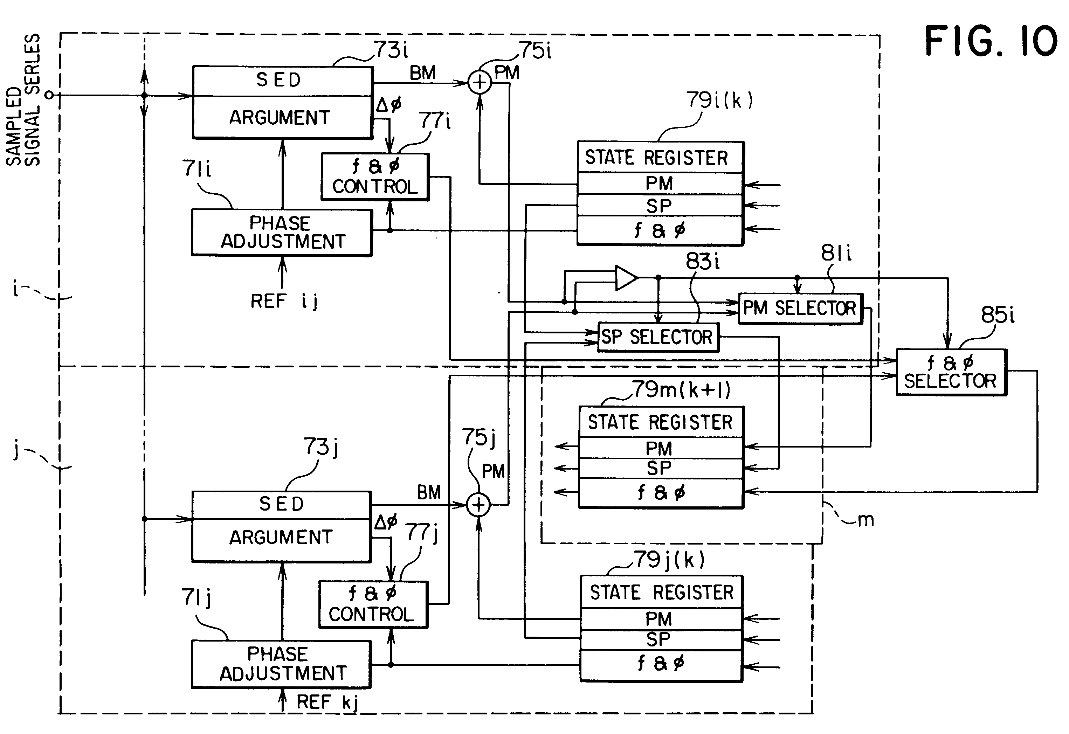

Fig. 10 is a block diagram showing the structure of the Viterbi algorithm arithmetic part 68 of the phase synchronous type maximum likelihood decoder for calculating the branch metric after the reference signal is shifted the phase.

It is the different point in Fig. 10 from Fig. 5, that the origin signal r_{ef} and the phase shift amount are input into the phase adjusting part 71i, and the output of the phase adjusting part 71i is output to the branch metric calculate part 73i.

Next, further another embodiment will be explained.

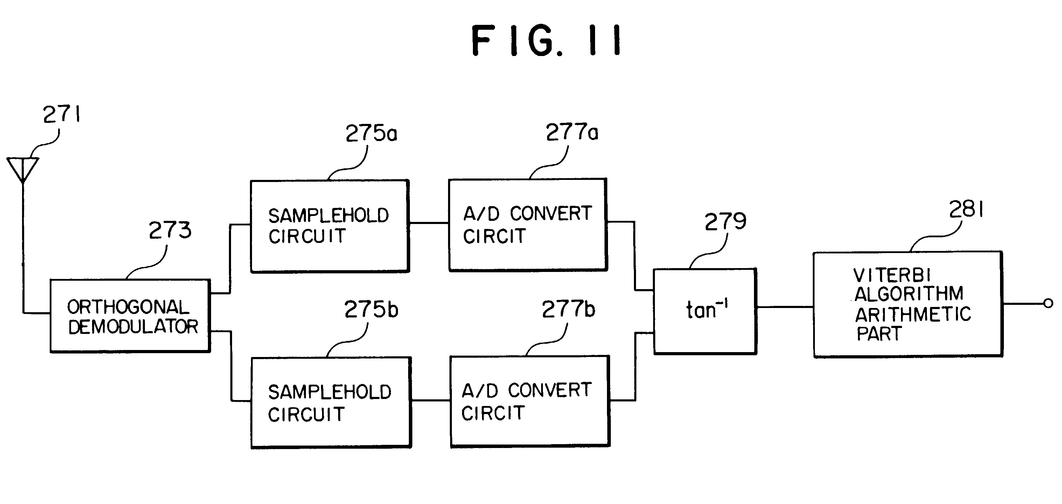

Fig. 11 is a block diagram showing the structure of the receive device having the Viterbi algorithm phase synchronous type maximum likelihood decoder. The receive device is provided with an antenna 271, an orthogonal demodulator 273, sample hold circuits 275a and 275b, analog-digital convert circuits (A/D converter) 277a and 277b, an angle convert circuit (tan⁻¹) 279 and a Viterbi algorithm arithmetic part 281.

The receive device of Fig. 11 is effective for the phase of CPESK, MPSK and MSK etc. or the modulation system relating to the frequency.

The orthogonal demodulator 273 demodulates orthogonally the signal received in the antenna 271 by using the asynchronous carrier generated in the built-in local generator (not shown), and transmits two channels of signals (I channel and Q channel) to the samplehold circuit 275a and 275b. The samplehold circuits 275a and 275b samplehold the signal transmitted from the orthogonal demodulator 273. The analog-digital convert circuits 277a and 277b convert the analog signals transmitted from the samplehold circuits 275a and 275b into the digital signals. The angle convert circuit 279 converts the signals transmitted from the analog-digital circuits 277a and 277b into the signals indicating the phase. By converting the signal into the signal indicating the phase, it can be proceeded the adding arithmetic in the phase shift amount calculation to make the calculated amount to be remarkably small as possible. The Viterbi algorithm arithmetic part 281 proceeds the arithmetic of the Viterbi algorithm described later to the signal indicating the phase transmitted from the angle convert circuit 279.

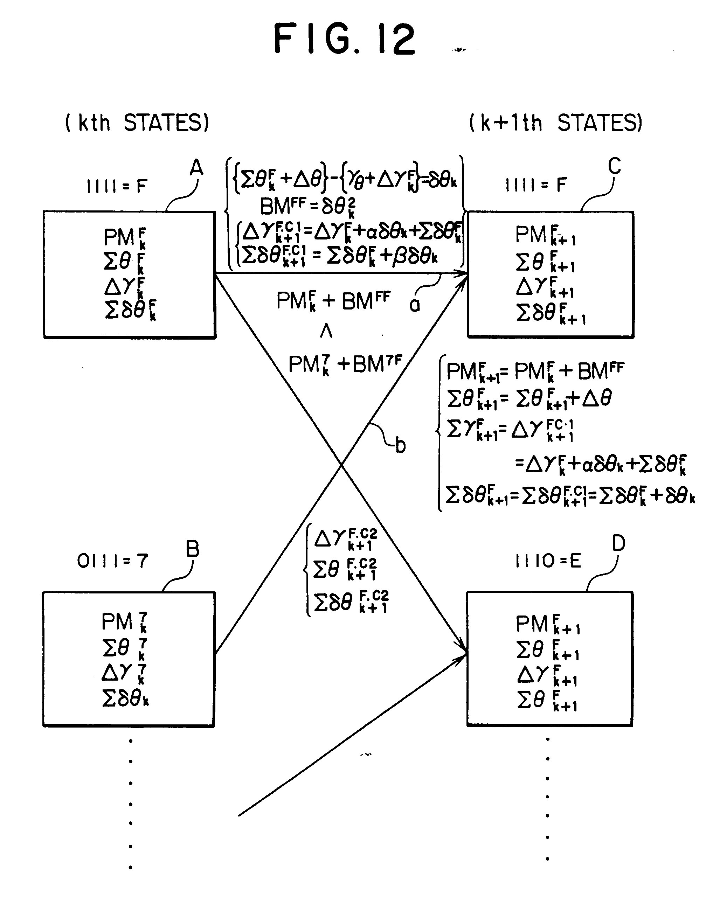

Fig. 12 is a state transition diagram showing the Viterbi algorithm used in the present embodiment.

The states A, B, C and D in the Viterbi algorithm have the amount of the states of the path metric (PM), the accumulated reference phase, the phase shift amount r and the accumulated frequency. These values are memorized in the memory during the arithmetic.

The states A and B indicate the difference states in the time k. The state A is "F" (= 1111) state and the state B is "7" (= 0111) state. And the states C and D indicate the different states in the time k+1. The state C is "F" (= 1111) state and the state D is "E" (= 1110) state.

The suffix corresponding to each state is added the above described path metric (PM) and the accumulated reference phase Σθ etc. For example, PMₖ designates the Fth state in the time k, namely, the path metric in the state A.

In this algorithm, the phase transition amounted Δθ when transited from the "state ₖ" to the "state ₖ" is used as the reference of the ideal input signal.

In the conditions A and B, the path metric PM, the accumulated reference phase Σθ, the phase shift amount Δγ, and the accumulated frequency Σδθ are already obtained and memorized in the memory.

Next, the branch metric BM will be calculated. The branch metric BM is obtained by evaluating the difference between the input signal in the time k which is the vector on the complex plane and each reference signal.

In the present embodiment, the accumulated reference phase Σθ stored in the state to be the threshold of the branch as the reference signal is added to the ideal phase transition amount Δθ(Δθ=π/2 when it is from "1111" to "1111" in the GMSK) caused when it is passed through the branch. As the input signal, it is used the input signal r added with the phase shift amount Δr^{F}. Namely, the input phase signal rθ is shifted the phase therein the phase shift amount Δr^{F}.

The input phase signal rθ is transmitted from the angle convert circuit 279 to the Viterbi algorithm arithmetic part 281.

The phase error can be obtained by the following arimetic.${\text{(Σθ}}_{\text{k}} {\text{+ Δθ) - (rθ+Δr}}_{\text{k}} {\text{) =δθ}}_{\text{k}}$

Next, the branch metric BM^{FF} can be obtained in accordance with the following formula from the obtained phase error.${\text{BM}}^{\text{FF}} {\text{= δθ}}_{\text{k}}$

Further, the phase shift amount Δr and the accumulated frequency Σδθ will be adjusted by the following formula.${\text{Σr}}_{\text{k+1}} {\text{=Δr}}_{\text{k}} {\text{+ αδθ}}_{\text{k}} {\text{+ Σδθ}}_{\text{k}}$${\text{Σδθ}}_{\text{k+1}} {\text{= Σδθ}}_{\text{k}} {\text{+ βδθ}}_{\text{k}}$

Here, the suffix C1 designates the candidate when it is passed through the branch a, and the suffix C2 is added when it is passed through the branch b.

Next, the select of the path to the state C will be carried out by the ACS (Add Compare Select) arithmetic.

In the figure, as the path to the state C, there exist the path from the state A to the state C, and the path from the state B to the state C. The probability from the state A to the state C is obtained by adding the path metric PMₖ of the state A with the branch metric BM^{FF} selecting the branch from the state A to the state C. Namely, the path metric of the state C passing through the branch a to the state C becomes PMₖ + BM^{FF}. As compared with this, the path metric of the state C passing through the branch b to the state C becomes PMₙ + BM^{7F}.

Next, it is determined which branch is selected from the branch a and b on comparing the sum of the path metric candidate and the branch metric as obtained above.

Here, if it is PMₖ + BM^{FF} < PM^{k} + BM^{7F}, it is considered that the state C is transited from the state A through the branch a (in this case, it is made to select the smaller path metric).

Therefore, in the state C, the path metric PM, the accumulated reference phase Σθ, the phase shift amount Σγ, and the accumulated frequency Σδθ can be obtained by the following formula.${\text{PM}}_{\text{k+1}} {\text{= PM}}_{\text{k}} {\text{+ BM}}^{\text{FF}}$${\text{Σθ}}_{\text{k+1}} {\text{= Σθ}}_{\text{k+1}} \text{+ Δθ}$${\text{Σγ}}_{\text{k+1}} {\text{= Δγ}}_{\text{k+1}} {\text{= Δγ}}_{\text{k}} {\text{+ αδθ}}_{\text{k}} {\text{+ Σδθ}}_{\text{k}}$${\text{Σδθ}}_{\text{k+1}} {\text{= Σδθ}}_{\text{k+1}} {\text{= Σδθ}}_{\text{k}} \text{+ δθ}$

As described above, new phase shift amount can be selected in the phase shift amount candidates.

The maximum likelihood determination as mentioned above is carried out sequentially for every time.

The present invention allows the other variations.

For example, the secondary loop control utilizing the primary loop filter is carried out in the above described embodiment, it is also possible to utilize the primary or exceeding the tertiary.

For the application of the present invention, the arithmetic of the ACS can be utilized for the software or the hardware in the processor.

Further, as the modulated signal which is capable of being utilized in the present invention, it can be exampled the convolution coded signal, the coded modulation signal, and the linear modulations GMSK, CPFSK and CQPSK etc. including the convolutionally coded QAM, PSM, and ISI.

## Claims

1. A phase synchronous type maximum likelihood decoder, characterised in that said decoder comprises:
a memory means (57A-57N) for memorizing N number of partial series possibly transmitted from a transmit side;
N number of phase adjust means (55A-55N) for adjusting a phase of received data series on the basis of partial series memorized in said memory means (57A-57N);
means (59A-59N) for calculating a likelihood of partial series memorized in said memory means (57A-57N) and adjusted phase output from said phase adjust means (55A-55N); and
means (61) for comparing N number of calculated likelihood and for selecting partial series having the maximum likelihood from said memory means (57A-57N).

2. A phase synchronous type maximum likelihood decoder, when defining a state i (i = 1, ---, M) indicating partial series of transmit data series possibly transmitted from transmit side in every time of time k (k = 1, ---, N); and
defining a transition, in the transition a certain state in time k transit to other state in time (k+1);
the phase synchronous type maximum likelihood decoder presuming transmitted transmit data series by following said state through each transition and synthesizing said partial series, characterized in that said decoder comprises:
a memory means (79i) for memorizing path metric and phase shift amount of the state i in the time k;
a phase adjust means (71i) for shifting the phase of input signal in the time (k+1) to the phase shift amount in the state i;
a branch metric calculate means (73i) for calculating a branch metric on evaluating the difference between a reference signal corresponding to a transition for the state m among a plurality of states in the time (k + 1) possibly transit from the state i in the state i and an input signal having an adjusted phase output from said phase adjust means (71i);
a phase error calculate means (74i) for calculating a phase error as an angle difference between said input signal having adjusted phase output from said phase adjust means and said reference signal in the state i;
a path metric candidate calculate means (75i) for calculating a path metric candidate of the state m in the time (k + 1) by synthesizing a path metric of the state i in the time k memorized in said memory means (79i) and a branch metric output from said branch metric calculate means (73i) in said state i;
a path metric set means (81i) for setting a path metric of the state in the time (k + 1) by comparing a plurality of path metric candidates calculated by said path metric candidate calculate means (75i) in accordance with the transition from the state i in the time k to the state j in the time (k + 1);
a phase shift amount calculate means (77i) for calculating a phase shift amount candidate of the state m on the basis of said phase shift amount of the state i in the time k memorized in said memorize means (79i) and said phase error; and
a phase shift amount set means (85i) for setting said phase shift amount candidate accorded to either one of selected transition among the transitions from the states i and j in the time k to the state m in the time (k + 1) as a phase shift amount.

3. A phase synchronous type maximum likelihood decoder,
when defining a state i (i = 1, ---, M) indicating partial series of transmit data series possibly transmitted from transmit side in every time of time k (k = 1, ---, N); and
defining a transition in the transition a certain state in time k transit to other state in time (k+1);
the phase synchronous type maximum likelihood decoder presuming transmitted transmit data series by following said state through each transition and synthesizing said partial series, characterised in that said decoder comprises:
a memory means (79i) for memorizing path metric and phase shift amount of the state i in the time k;
a phase adjust means (71i) for shifting a reference signal accorded to each transition to the state m among a plurality of states in the time (k + 1) possibly transited from the state i in the time k in the phase shift amount in the time k memorized in said memory means;
a branch metric calculate means (73i) for calculating a branch metric on evaluating the difference between an input signal in the time (k + 1) and a reference signal having an adjusted phase output from said phase adjust means in the state i;
a phase error calculate means (74i) for calculating a phase error as an angle difference between said input signal in the time (k + 1) and said reference signal having adjusted phase output from said phase adjust means (71i) in the state i;
a path metric candidate calculate means (75i) for calculating a path metric candidate of the state m in the time (k + 1) by synthesizing a path metric of the state i in the time k memorized in said memory means and a branch metric output from said branch metric calculate means (73i) in said state i;
a path metric set means (81i) for setting a path metric of the state in the time (k + 1) by comparing a plurality of path metric candidates calculated by said path metric candidate calculate means (75i) in accordance with the transition from the state i in the time k to the state j in the time (k + 1);
a phase shift amount calculate means (77i) for calculating a phase shift amount candidate of the state m on the basis of said phase shift amount of the state i in the time k memorized in said memorize means (79i) and said phase error; and
a phase shift amount set means (85i) for setting said phase shift amount candidate accorded to either one of selected transition among the transitions from the states i and j in the time k to the state m in the time (k + 1) as a phase shift amount.

4. A phase synchronous type maximum likelihood decoder according to claim 2 or 3, wherein said input signal is converted into an angle.

## Patentansprüche

1. Phasensynchroner Maximum-Likelihood-Decodierer, dadurch gekennzeichnet, daß der Decodierer aufweist:
eine Speichereinrichtung (57A-57N) zum Speichern einer Anzahl N von partiellen Serien, die möglicherweise von einer Sendeseite übertragen werden;
eine Anzahl N von Phasenabgleicheinrichtungen (55A-55N) zum Abgleichen einer Phase von empfangenen Datenserien auf der Grundlage von partiellen Serien, die in der Speichereinrichtung (57A-57N) gespeichert sind;
eine Einrichtung (59A-59N) zum Berechnen einer Stichprobenwahrscheinlichkeit von partiellen Serien, die in der Speichereinrichtung (57A-57N) gespeichert sind, und einer abgeglichenen Phase, die von der Phasenabgleicheinrichtung (55A-55N) ausgegeben wird; und
eine Einrichtung (61) zum Vergleichen einer Anzahl N von berechneten Stichprobenwahrscheinlichkeiten und zum Wählen von partiellen Serien mit der maximalen Stichprobenwahrscheinlichkeit aus der Speichereinrichtung (57A-57N).

2. Phasensynchroner Maximum-Likelihood-Decodierer, wenn ein Zustand i (i = 1, ---, M) definiert wird, der partielle Serien von Übertragungsdatenserien anzeigt, die möglicherweise von der Sendeseite übertragen werden, in jeder Zeit der Zeit k (k = 1, ---, N); und
ein Übergang definiert wird, im Übergang, in dem ein bestimmter Zustand in einer Zeit k in einen anderen Zustand in einer Zeit (k + 1) übergeht;
wobei der phasensynchrone Maximum-Likelihood-Decodierer übertragene Übertragungsdatenserien voraussagt, indem er dem Zustand durch jeden Übergang folgt und die partiellen Serien synthetisiert, dadurch gekennzeichnet, daß der Decodierer aufweist:
eine Speichereinrichtung (79i) zum Speichern einer Pfadmetrik und eines Phasenverschiebungsbetrags des Zustands i in der Zeit k;
eine Phasenabgleicheinrichtung (71i) zum Verschieben der Phase des Eingangssignals in der Zeit (k + 1) bis zum Phasenverschiebungsbetrag im Zustand i;
eine Zweigmetrikberechnungseinrichtung (73i) zum Berechnen einer Zweigmetrik nach einem Bewerten der Differenz zwischen einem Referenzsignal, das einem Übergang für den Zustand m unter einer Vielzahl von Zuständen in der Zeit (k + 1), der möglicherweise vom Zustand i übergegangen ist, im Zustand i entspricht, und einem Eingangssignal mit einer abgeglichenen Phase, die von der Phasenabgleicheinrichtung (71i) ausgegeben wird;
eine Phasenfehlerberechnungseinrichtung (74i) zum Berechnen eines Phasenfehlers als Winkeldifferenz zwischen dem Eingangssignal mit der abgeglichenen Phase, das von der Phasenabgleicheinrichtung ausgegeben wird, und dem Referenzsignal im Zustand i;
eine Pfadmetrikkandidatenberechnungseinrichtung (75i) zum Berechnen eines Pfadmetrikkandidaten des Zustands m in der Zeit (k + 1) durch Synthetisieren einer Pfadmetrik des Zustands i in der Zeit k, die in der Speichereinrichtung (79i) gespeichert wird, und einer Zweigmetrik, die von der Zweigmetrikberechnungseinrichtung (73i) in dem Zustand i ausgegeben wird;
eine Pfadmetrikeinstelleinrichtung (81i) zum Einstellen einer Pfadmetrik des Zustands in der Zeit (k + 1) durch Vergleichen einer Vielzahl von Pfadmetrikkandidaten, die durch die Pfadmetrikkandidatenberechnungseinrichtung (75i) entsprechend dem Übergang von dem Zustand i in der Zeit k in den Zustand j in der Zeit (k + 1) berechnet werden;
eine Phasenverschiebungsbetragsberechnungseinrichtung (77i) zum Berechnen eines Phäsenverschiebungsbetragskandidaten des Zustands m auf der Grundlage des Phasenverschiebungsbetrags des Zustands i in der Zeit k, der in der Speichereinrichtung (79i) gespeichert ist, und des Phasenfehlers; und
eine Phasenverschiebungsbetragseinstelleinrichtung (85i) zum Einstellen des Phasenverschiebungsbetragskandidaten entsprechend einem der gewählten Übergänge unter den Übergängen von den Zuständen i und j in der Zeit k in den Zustand m in der Zeit (k + 1) als Phasenverschiebungsbetrag.

3. Phasensynchroner Maximum-Likelihood-Decodierer, ein Zustand i (i = 1, ---, M) definiert wird, der partielle Serien von Übertragungsdatenserien anzeigt, die möglicherweise von einer Sendeseite übertragen werden, in jeder Zeit der Zeit k (k = 1, ---, N); und
ein Übergang definiert wird, im Übergang, in dem ein bestimmter Zustand in einer Zeit k in einen anderen Zustand in einer Zeit (k + 1) übergeht;
wobei der phasensynchrone Maximum-Likelihood-Decodierer übertragene Übertragungsdatenserien voraussagt, indem er dem Zustand durch jeden Übergang folgt und die partiellen Serien synthetisiert, dadurch gekennzeichnet, daß der Decodierer aufweist:
eine Speichereinrichtung (79i) zum Speichern einer Pfadmetrik und eines Phasenverschiebungsbetrags des Zustands i in der Zeit k;
eine Phasenabgleicheinrichtung (71i) zum Verschieben eines Referenzsignals entsprechend jedem Übergang in den Zustand m unter einer Vielzahl von Zuständen in der Zeit (k + 1), der möglicherweise vom Zustand i in der Zeit k übergegangen ist, im Phasenverschiebungsbetrag in der Zeit k, der in der Speichereinrichtung gespeichert ist;
eine Zweigmetrikberechnungseinrichtung (73i) zum Berechnen einer Zweigmetrik nach einem Bewerten der Differenz zwischen einem Eingangssignal in der zeit (k + 1) und einem Referenzsignal mit einer abgeglichenen Phase, die von der Phasenabgleicheinrichtung im Zustand i ausgegeben wird;
eine Phasenfehlerberechnungseinrichtung (74i) zum Berechnen eines Phasenfehlers als Winkeldifferenz zwischen dem Eingangssignal in der zeit (k + 1) und dem Referenzsignal, das von der Phasenabgleicheinrichtung (71i) im Zustand i ausgegeben wird;
eine Pfadmetrikkandidatenberechnungseinrichtung (75i) zum Berechnen eines Pfadmetrikkandidaten des Zustands m in der Zeit (k + 1) durch Synthetisieren einer Pfadmetrik des Zustands i in der Zeit k, die in der Speichereinrichtung gespeichert wird, und einer Zweigmetrik, die von der Zweigmetrikberechnungseinrichtung (73i) in dem Zustand i ausgegeben wird;
eine Pfadmetrikeinstelleinrichtung (81i) zum Einstellen einer Pfadmetrik des Zustands in der Zeit (k + 1) durch Vergleichen einer Vielzahl von Pfadmetrikkandidaten, die durch die Pfadmetrikkandidatenberechnungseinrichtung (75i) entsprechend dem Übergang von dem Zustand i in der Zeit k in den Zustand j in der Zeit (k + 1) berechnet werden;
eine Phasenverschiebungsbetragsberechnungseinrichtung (77i) zum Berechnen eines Phasenverschiebungsbetragskandidaten des Zustands m auf der Grundlage des Phasenverschiebungsbetrags des Zustands i in der Zeit k, der in der Speichereinrichtung (79i) gespeichert ist. und des Phasenfehlers; und
eine Phasenverschiebungsbetragseinstelleinrichtung (85i) zum Einstellen des Phasenverschiebungsbetragskandidaten entsprechend einem der gewählten Übergänge unter den Übergängen von den Zuständen i und j in der Zeit k in den Zustand m in der Zeit (k + 1) als Phasenverschiebungsbetrag.

4. Phasensynchroner Maximum-Likelihood-Decodierer nach Anspruch 2 oder 3, wobei das Eingangssignal in einen Winkel verwandelt wird.

## Revendications

1. Un décodeur à probabilité maximale synchrone en phase, caractérisé en ce que ledit décodeur comprend:
une mémoire (57A-57N) pour mémoriser un nombre N de séries partielles, qui sont éventuellement transmises à partir d'un côté de transmission;
un nombre N d'ajusteurs de phase (55A-55N) pour ajuster une phase de séries de données reçues sur la base de séries partielles, qui sont mémorisées dans ladite mémoire (57A-57N);
un calculateur (59A-59N) pour calculer une probabilité au hasard de séries partielles, qui sont mémorisées dans ladite mémoire (57A-57N), et un signal de sortie de phase ajustée, qui est transmis par lesdits ajusteurs de phase (55A-55N); et
un moyen (61) pour comparer un nombre N de probabilités au hasard calculées et pour sélectionner à partir de ladite mémoire (57A-57N) des séries partielles ayant la probabilité au hasard maximale.

2. Un décodeur à probabilité maximale synchrone en phase, qui, lorsqu'un état i (i = 1, ---, M) est défini, indique des séries partielles de séries de données de transmission, qui sont éventuellement transmises à partir du côté de transmission, au cours de chaque période de temps du temps k (k = 1, ---, N); et
une transition est définie, transition dans laquelle un état donné au temps k transite vers un autre état au temps (k + 1);
alors que le décodeur à probabilité maximale synchrone en phase présume des séries de données de transmission transmises, en suivant ledit état à travers chaque transition et en synthétisant lesdites séries partielles, caractérisé en ce que ledit décodeur comprend:
une mémoire (79i) pour mémoriser une métrique de chemin et la valeur de déphasage de l'état i au temps k;
un ajusteur de phase (71i) pour décaler la phase du signal d'entrée au temps (k + 1) jusqu'à la valeur de déphasage à l'état i;
un calculateur de métrique d'embranchement (73i) pour calculer une métrique d'embranchement en évaluant la différence entre un signal de référence, qui correspond à une transition pour l'état m parmi une pluralité d'états au temps (k + 1), qui a éventuellement transité de l'état i, dans l'état i, et un signal d'entrée ayant un signal de sortie de phase ajustée venant dudit ajusteur de phase (71i);
un calculateur d'erreur de phase (74i) pour calculer une erreur de phase comme étant une différence d'angle entre ledit signal d'entrée ayant un signal de sortie de phase ajustée venant dudit ajusteur de phase et ledit signal de référence à l'état i:
un calculateur de candidat de métrique de chemin (75i) pour calculer un candidat de métrique de chemin de l'état m au temps (k + 1) en synthétisant une métrique de chemin de l'état i au temps k, qui est mémorisée dans ladite mémoire (79i), et un signal de sortie de la métrique d'embranchement venant dudit calculateur de métrique d'embranchement (73i) dans ledit état i;
un moyen de réglage de métrique de chemin (81i) pour régler une métrique de chemin de l'état au temps (k + 1) en comparant une pluralité de candidats de métrique de chemin calculés par ledit calculateur de candidats de métrique de chemin (75i) en fonction de la transition de l'état i au temps k vers l'état j au temps (k + 1);
un calculateur de la valeur de déphasage (77i) pour calculer un candidat de valeur de déphasage de l'état m en prenant comme base ladite valeur de déphasage de l'état i au temps k, qui est mémorisée dans ladite mémoire (79i) et ladite erreur de phase; et
un moyen de réglage de la valeur de déphasage (85i) pour régler ledit candidat de valeur de déphasage en fonction d'une des transitions sélectionnées parmi les transitions des états i et j au temps k vers l'état m au temps (k + 1) comme une valeur de déphasage.

3. Un décodeur à probabilité maximale synchrone en phase, qui, lorsqu'un état i (i = 1, ---, M) est défini, indique des séries partielles de séries de données de transmission, qui sont éventuellement transmises à partir du côté de transmission, au cours de chaque période de temps du temps k (k = 1, ---, N); et
une transition est définie, transition dans laquelle un état donné au temps k transite vers un autre état au temps (k + 1);
alors que le décodeur à probabilité maximale synchrone en phase présume des séries de données de transmission transmises, en suivant ledit état à travers chaque transition et en synthétisant lesdites séries partielles, caractérisé en ce que ledit décodeur comprend:
une mémoire (79i) pour mémoriser une métrique de chemin et la valeur de déphasage de l'état i au temps k;
un ajusteur de phase (71i) pour décaler un signal de référence en fonction de chaque transition vers l'état m parmi une pluralité d'états au temps (k + 1), qui a éventuellement transité de l'état i au temps k vers la valeur de déphasage au temps k, qui est mémorisée dans ladite mémoire;
un calculateur de métrique d'embranchement (73i) pour calculer une métrique d'embranchement en évaluant la différence entre un signal d'entrée au temps (k + 1) et un signal de référence ayant un signal de sortie de phase ajustée venant dudit ajusteur de phase à l'état i;
un calculateur d'erreur de phase (74i) pour calculer une erreur de phase comme étant une différence d'angle entre ledit signal d'entrée au temps (k + 1) et ledit signal de référence ayant un signal de sortie de phase ajustée venant dudit ajusteur de phase (71i) dans l'état i:
un calculateur de candidat de métrique de chemin (75i) pour calculer un candidat de métrique de chemin à l'état m au temps (k + 1) en synthétisant une métrique de chemin à l'état i au temps k, qui est mémorisée dans ladite mémoire, et un signal de sortie de la métrique d'embranchement venant dudit calculateur de métrique d'embranchement (73i) à l'état i;
un moyen de réglage de métrique de chemin (81i) pour régler une métrique de chemin de l'état au temps (k + 1) en comparant une pluralité de candidats de métrique de chemin calculés par ledit calculateur de candidats de métrique de chemin (75i) en fonction de la transition de l'état i au temps k vers l'état j au temps (k + 1);
un calculateur de la valeur de déphasage (77i) pour calculer un candidat de valeur de déphasage de l'état m en prenant comme base ladite valeur de déphasage de l'état i au temps k, qui est mémorisée dans ladite mémoire (79i) et ladite erreur de phase; et
un moyen de réglage de la valeur de déphasage (85i) pour régler ledit candidat de valeur de déphasage en fonction d'une des transitions sélectionnées parmi les transitions des états i et j au temps k vers l'état m au temps (k + 1) comme une valeur de déphasage.

4. Un décodeur à probabilité maximale synchrone en phase suivant la revendication 2 ou 3, dans lequel ledit signal d'entrée est transformé en un angle.
